Europäisches Patentamt

European Patent Office

Office européen des brevets

(19)

(11) Publication number: **0 053 877**

**A2**

(12)

# EUROPEAN PATENT APPLICATION

(21) Application number: **81305237.0**

(22) Date of filing: **04.11.81**

(51) Int. Cl.³: **G 11 C 11/24**

(30) Priority: **04.11.80 JP 154811/80**

(43) Date of publication of application:
**16.06.82 Bulletin 82/24**

(84) Designated Contracting States:
**DE FR GB NL**

(71) Applicant: **FUJITSU LIMITED**
**1015, Kamikodanaka Nakahara-ku**
**Kawasaki-shi Kanagawa 211(JP)**

(72) Inventor: **Takemae, Yoshihiro**
**1-20-5-9-301 Utsukushigaoka Midori-ku**
**Yokohama-shi Kanagawa 227(JP)**

(74) Representative: **Fane, Christopher Robin King et al,**
**HASELTINE LAKE & CO. Hazlitt House 28 Southampton**
**Buildings Chancery Lane**
**London, WC2A 1AT(GB)**

(54) Bit-line pre-charge circuit for a dynamic semiconductor memory device.

(57) Disclosed is a dynamic-type semiconductor memory device comprising a group of sense amplifiers (SA), a plurality of pairs of bit lines (BL, $\overline{BL}$) extending from the sense amplifiers, and a plurality of dynamic-type memory cells (MC) connected to each bit line. Each pair of bit lines is short circuited and then precharged to a high potential level before a reading operation. A control line ($N_1'$) activating the sense amplifiers is commonly used as a control line for bringing about the precharging of each pair of bit lines, thereby assisting in attainment of high degree of integration and a high short-circuiting speed.

Fig. 3

SEMICONDUCTOR MEMORY DEVICE

The present invention relates to a semiconductor memory device in which a short between a pair of bit lines, and a charging up of the bit lines, are executed before a reading operation.

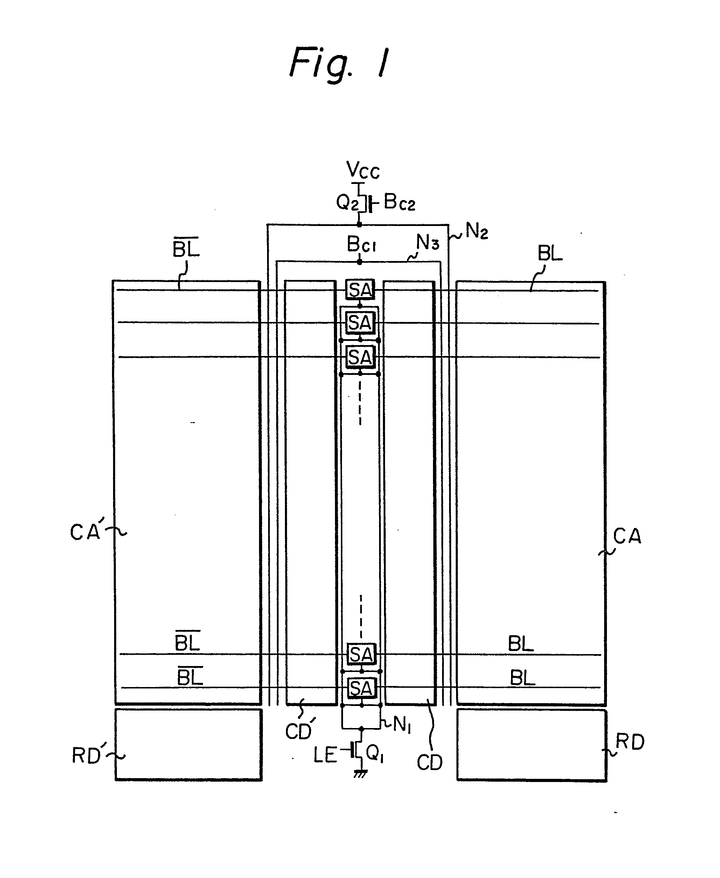

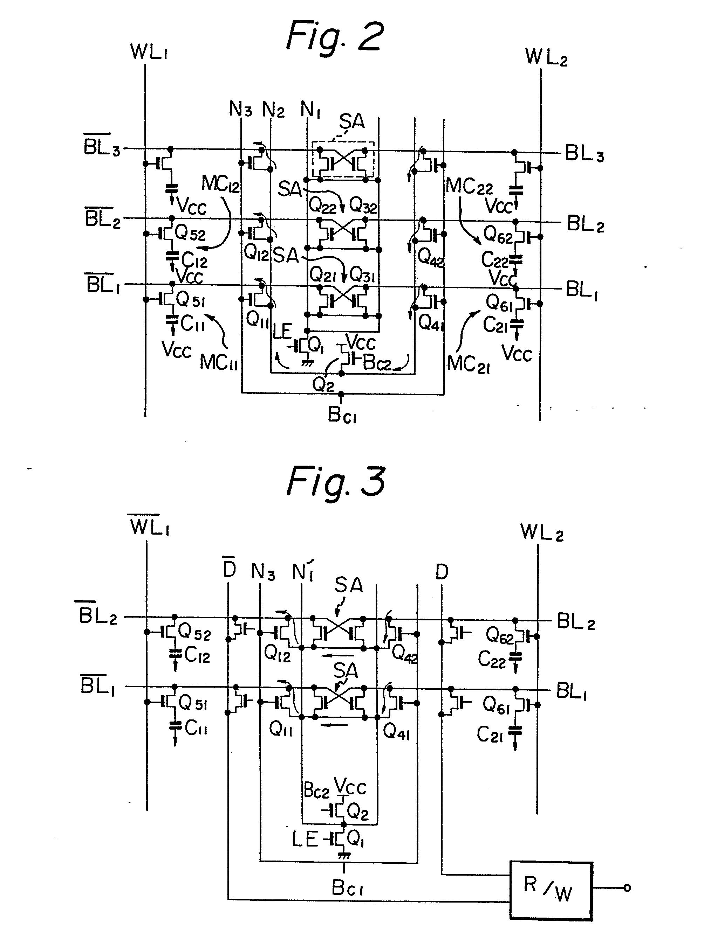

A dynamic RAM (Random Access Memory) of one transistor-one capacitor type usually has a structure as illustrated in Fig. 1, comprising a group of sense amplifiers SA arranged in the middle portion of the RAM; column decoders CD and CD' and cell arrays CA and CA' arranged on both sides of the sense amplifiers; pairs of bit lines BL and $\overline{BL}$ extending horizontally across these column decoders and cell arrays, the column decoders selecting one of the pairs of the bit lines; row decoders RD and RD' for selecting one of the word lines (not shown) extending vertically across the cell arrays CA and CA'. Fig. 2 is a circuit diagram illustrating a main portion of the sense amplifiers SA and their periphery in detail in the RAM of Fig. 1 (see, for example, IBM Technical Disclosure Bulletin vol. 20 No. 5 October 1977, pp1714-1715), wherein, $Q_{11}$ , $Q_{12}$ , ..., $Q_{41}$ , $Q_{42}$ , ... represent transistors for shorting and precharging the pairs of the bit lines ($BL_1$ , $\overline{BL}_1$), ($BL_2$ , $\overline{BL}_2$), .... Each sense amplifier SA is in a form of a flip flop consisting of two transistors $Q_{21}$ and $Q_{31}$ , $Q_{22}$ and $Q_{32}$ , .... All of the sense amplifiers are commonly associated to a first control line $N_1$ for driving the sense amplifiers. The source (or drain), the gate and the drain (or source) of the transistor $Q_{11}$ are connected to a second control line $N_2$ , a third control line $N_3$ and the bit line $\overline{BL}_1$ , respectively. The other precharging and shorting transistors are also connected to the second control line $N_2$, the third control line $N_3$, and the respective bit lines similar to the transistor $Q_{11}$. Memory cells $MC_{11}$ , $MC_{12}$ , ..., $MC_{21}$ , $MC_{22}$ , ... are connected between the bit lines and a word line, respectively. Each memory cell consists of one transistor and one capacitor. For example, the memory cell $MC_{11}$ consists of a transistor $Q_{51}$ having a drain connected to the bit line $\overline{BL}_1$, a gate connected to the word line $WL_1$ and a source connected to one electrode of a capacitor $C_{11}$ whose opposite electrode is connected to the power supply $V_{cc}$.

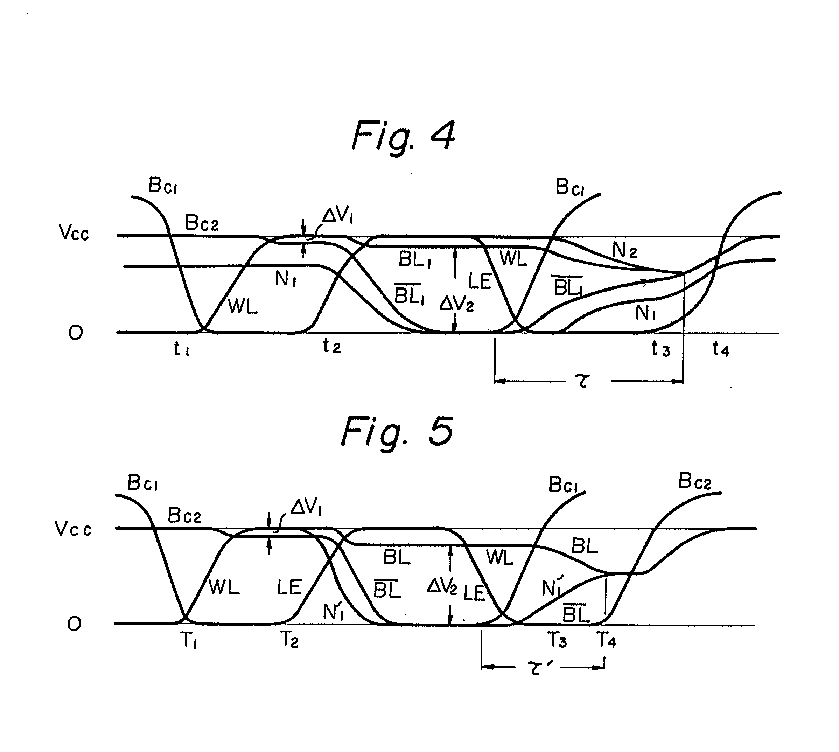

In the operation of the RAM as illustrated in Figs. 1 and 2, the pairs of the bit lines BL and $\overline{BL}$ are charged up to a high potential level (generally to a power supply potential $V_{cc}$) before reading the information stored in a cell. Before the precharging, a short circuit is effected between each pair of the bit lines for equalizing the potential at the bit lines. That is, the transistors $Q_{11}$, $Q_{12}$, ..., $Q_{41}$, $Q_{42}$, ... are conducted by setting the electric potential at the third control line $N_3$ to a high potential level higher than the power supply potential $V_{cc}$. The potential of the third control line $N_3$ is raised by applying the high potential of a clock signal $B_{c1}$ to the control line $N_3$ as illustrated in Fig. 4. A transistor $Q_2$ is inserted between the power supply $V_{cc}$ and the second control line $N_2$. A clock signal $B_{c2}$ is applied to the gate of the transistor $Q_2$. While the clock signal $B_{c2}$ is at a low level and therefore the transistor $Q_2$ is cutoff, a current flows in the arrowed directions illustrated in Fig. 2 from the bit lines at a high potential (in Fig. 2, from the side of the bit lines $BL_1$, $BL_2$, ...) to the bit lines at a low potential (in Fig. 2, to the side of the bit lines $\overline{BL}_1$, $\overline{BL}_2$, ...) so that the potentials of both bit lines are balanced at a time near the point $t_3$. After this, when the potential of the clock signal $B_{c2}$ is raised to a level higher than the power supply potential $V_{cc}$ at a time near the point $t_4$, the transistor $Q_2$ is turned on so that the pairs of the bit lines $(BL_1, \overline{BL}_1)$, $(BL_2, \overline{BL}_2)$ ... are precharged to the power supply potential $V_{cc}$.

In the reading operation, the clock signals $B_{c1}$ and $B_{c2}$ are turned to the low level so that the control line $N_2$ and

the bit lines BL and $\overline{BL}$ are brought into a floating state. Then, one of the word lines $WL_2$ is selected by the row decoder so that the selected word line is turned to the high potential level $V_{cc}$ at a time $t_1$. At the same time, the corresponding dummy word line DWL (not shown) is also selected to be the high potential level $V_{cc}$. Thus, the selected memory cell and its corresponding dummy cell are connected to the respective bit lines BL and $\overline{BL}$. For example, when the memory cell $MC_{21}$ and its dummy cell $DC_{11}$ (not shown) are selected and the memory cell $MC_{21}$ stores the information "1", charges on the bit line $\overline{BL}_1$ flow into the capacitor of the dummy cell $DC_{11}$ but charges on the bit line $BL_1$ do not flow into the capacitor $C_{21}$. Therefore, a small potential difference is produced between the pair of bit lines $BL_1$ and $\overline{BL}_1$. When such a small potential difference $\Delta V_1$ is produced between the bit lines $BL_1$ and $\overline{BL}_1$ at a time $t_2$ , a clock signal LE is raised to the high potential level $V_{cc}$. The clock signal LE is applied to the gate of the transistor $Q_1$ which is inserted between the first control line $N_1$ and the ground. Thus, the potential of the control line $N_1$ is decreased to zero volts so that the sense amplifiers SA are activated. Due to the potential difference $\Delta V_1$ between the bit lines $BL_1$ and $\overline{BL}_1$ , one of the transistors in the sense amplifier, for example, the transistor $Q_{21}$ is turned on and the other transistor in the sense amplifier, for example, the transistor $Q_{31}$ is turned off. As a result, a large potential difference $\Delta V_2$ is obtained between the bit lines $BL_1$ and $\overline{BL}_1$. This potential difference is transferred through data lines (not shown in Fig. 2) to a read/write amplifier (not shown in Fig. 2) and amplified therein.

However, there are disadvantages in the circuit configuration of the conventional RAM illustrated in Figs. 1 and 2. That is, the second control line $N_2$ for precharging and shorting the bit lines is provided which is too long because the bit lines BL and $\overline{BL}$ are separated by the sense amplifiers and therefore the control line $N_2$ must be wired

taking a long way around the sense amplifiers. Therefore, the resistance of the control line $N_2$ is too large to short the bit lines rapidly even when the control line $N_2$ is wired by aluminum. Because of the large resitance of the control line $N_2$ , the bit line BL falls very slowly and the bit line $\overline{BL}$ rises very slowly as illustrated in Fig. 4. It takes a time period $\tau$ from the beginning of the rising of the clock signal $B_{cl}$ to the time when the potentials of the bit lines BL and $\overline{BL}$ are equalized. Further, in view of the high integration, the presense of the second control line $N_2$ is not preferable.

An embodiment of the present invention can provide a semiconductor memory device of a high integration degree.

An embodiment of the invention can also provide a semiconductor memory device operating at a high speed.

An embodiment of the invention can provide a semiconductor memory device in which a control line for activating sense amplifiers is commonly used as another control line for shorting and precharging pairs of bit lines when the sense amplifiers are in a state of standby, so as to eliminate the separate control line for shorting and precharging the pairs of bit lines.

According to the present invention, there is provided a semiconductor memory device comprising: a plurality of pairs of bit lines, each pair of the bit lines being short circuited and precharged to a high potential level before a reading operation; a plurality of word lines intersecting at the bit lines; a plurality of dynamic-type memory cells, each of the memory cells being connected between one of the bit lines and one of the word lines; and a plurality of sense amplifiers, each of the sense amplifiers having a terminal to activate the sense amplifier for detecting the potential difference between each pair of bit lines; characterised in that: a control line connected to the terminal for activating the sense amplifiers is commonly used as a control line for bringing about the precharging of each of the pairs of bit lines.

Brief Description of the Drawing

Objects and advantages as well as the characteristic features of the present invention will be more readily understood from the following description of the preferred embodiments with reference to the accompanying drawings in which the same reference characters designate the same or similar portions of the device, and wherein:

Fig. 1 is a block diagram illustrating an example of a conventional dynamic RAM;

Fig. 2 is a circuit diagram illustrating a main portion of the sense amplifiers and thier periphery in the RAM of Fig. 1;

Fig. 3 is a circuit diagram illustrating a main portion of sense amplifiers and their periphery, according to one embodiment of the present invention;

Fig. 4 is a graph illustrating waveforms for explaining the operation of the circuit of Fig. 2;

Fig. 5 is a graph illustrating waveforms for explaining the operation of the circuit of Fig. 3;

Fig. 6 is a circuit diagram illustrating another example of a conventional dynamic RAM; and

Fi.g 7 is a circuit diagram illustrating a dynamic RAM, according to another embodiment of the present invention.

Description of Preferred Embodiments

Fig. 3 is a circuit diagram illustrating the main portion of sense amplifiers and their periphery, according to one embodiment of the present invention. The main difference between the circuit of Fig. 2 and the circuit of Fig. 3 is that, instead of the first control line $N_1$ and the second control line $N_2$ in the circuit of Fig. 2, only one control line $N_1'$ is provided in the circuit of Fig. 3. That is, the second control line $N_2$ in Fig. 2 is eliminated in Fig. 3. Referring to Fig. 3, the sources or the drains of the transistors $Q_{11}$, $Q_{12}$, $\ldots$, $Q_{41}$, $Q_{42}$, $\ldots$ for shorting and charging up the pairs of the bit lines, which were connected to the second control line $N_2$ in the conventional circuit of Fig. 2, are connected to the control line $N_1'$ for driving the sense amplifiers SA. The source of the transistor $Q_2$ is connected, instead of being connected to the second control line $N_2$ in Fig. 2, to the control line $N_1'$. The other connections in the circuit of Fig. 3 are the same as the connections in the circuit of Fig. 2. Although only one memory cell connected to each bit line is illustrated for the purpose of simplicity in Figs. 2 and 3, a number of memory cells and a dummy memory cell are connected to each bit line in practice.

The operation of the circuit of Fig. 3 will now be explained with reference to Fig. 5, wherein the waveform of the clock signal $B_{c1}$ for driving the control line $N_3$ , the waveform of the clock signal LE for driving the transistor $Q_1$ , the waveform of the clock signal $B_{c2}$ for driving the transistor $Q_2$ , and the waveform of the word line WL are the same as those in the circuit of Fig. 2. However, the waveform of the control line $N_1'$ and accordingly the waveforms of the bit lines BL and $\overline{BL}$ in Fig. 5 are different from those of the first control line $N_1$ and the bit lines BL and $\overline{BL}$ in Fig. 4. That is, when the small potential difference $\Delta V_1$ is produced between the bit lines BL and $\overline{BL}$ after the word line WL is selected at a time $T_1$ to be raised to the high potential level $V_{cc}$ , the clock signal LE is raised to the $V_{cc}$ level at a time $T_2$ so that the transistor $Q_1$ is turned on, resulting in the control line $N_1'$ becoming zero volts. Then, the sense amplifiers SA are activated so that the potential difference between the bit lines BL and $\overline{BL}$ are expanded. A thus obtained large potential difference $\Delta V_2$ is transferred through data lines D, $\overline{D}$ to a read/write amplifier R/W and amplified therein. When the reading operation is completed, the potentials of the word line WL and the clock signal LE are lowered to zero volts. For the next reading operation, the potential of the clock signal $B_{c1}$ is raised to a level higher than $V_{cc}$ near the time $T_3$. Then, the tran-

sistors $Q_{11}$, $Q_{12}$, ..., $Q_{41}$, $Q_{42}$, ... are turned on so that each pair of the bit lines BL and $\overline{BL}$ are shorted to have the same electric potential at a time $T_4$. During this short period, a current flows from the bit line at the high potential through each sense amplifier to the bit line at the low potential. For example, when the bit line BL is at the high potential and the bit line $\overline{BL}$ is at the low potential, a current flows, in the direction of the arrows illustrated in Fig. 3, from the bit line BL through each sense amplifier to the bit line $\overline{BL}$ so that the electric potentials at the bit lines BL and $\overline{BL}$ and at the control line $N_1'$ are equalized. Therefore, the current for shorting the bit lines $BL_1$ and $\overline{BL}_1$ is conducted from the bit line $BL_1$ through the transistor $Q_{41}$, through the commonly connected drains of the pair of transistors in the sense amplifier, and through the transistor $Q_{11}$ to the bit line $\overline{BL}_1$. The other currents for shorting the bit lines BL and $\overline{BL}$ are also conducted through respective sense amplifiers. Thus, the short-circuit current does not flow through the control line $N_1'$. As a result, a rapid short and equalization of the potentials between the bit lines BL and $\overline{BL}$ can be effected according to this embodiment, because the resistance of the control line $N_1'$ does not affect the conduction of the short-circuit current. As illustrated in Fig. 5, it takes a time period $\tau'$ from the beginning of the rise of the clock signal $B_{c1}$ at the time $T_3$ to the time when the potentials of the bit lines BL and $\overline{BL}$ are equalized at the time $T_4$. The time period $\tau'$ is much smaller than the time period $\tau$ in Fig. 4. After this, at the time $T_5$, the clock signal $B_{c2}$ is raised to a high potential level higher than the power supply potential $V_{cc}$, so that the transistor $Q_2$ is turned on for precharging the bit lines BL and $\overline{BL}$ to the power supply potential $V_{cc}$. From the time $T_4$ when the short circuit is completed, to the time $T_5$ when the clock signal $B_{c2}$ is raised to the high potential level, the potential at the control line $N_1'$ rises from a level nearly equal to $V_{cc}/2$ to the power supply potential $V_{cc}$.

However, the sense amplifiers are not activated when the potential at the control line $N_1'$ is such a high level. The sense amplifiers are activated only when the control line $N_1'$ is lowered to zero volts after the potentials of the clock signals $B_{c1}$ and $B_{c2}$ are lowered to zero volts near the time $T_1$ and then the clock signal LE is raised to the $V_{cc}$ level to turn on the transistor $Q_1$ near the time $T_2$.

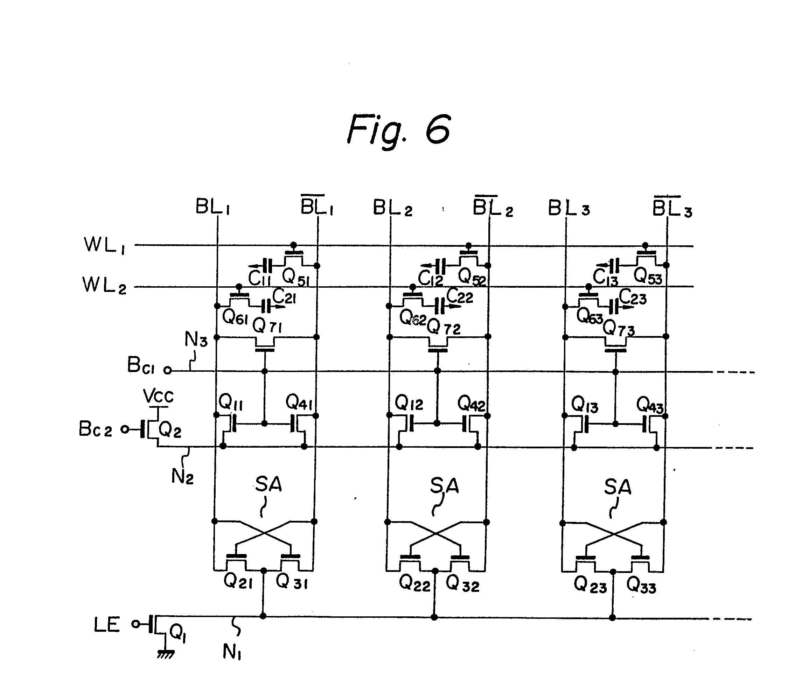

Fig. 6 is a circuit diagram illustrating another example of a conventional dynamic RAM. In Fig. 6, each pair of bit lines BL and $\overline{BL}$ are arranged in parallel, forming a so-called folded bit line structure. The transistors $Q_1$ , $Q_2$ , $Q_{11}$ , $Q_{21}$ , $Q_{31}$ , $Q_{41}$ , $Q_{51}$ , $Q_{61}$ , ... and the capacitors $C_{11}$ , $C_{12}$ , ... are connected in the same way as in the conventional circuit of Fig. 2. Also, the oprations of the clock signals LE, $B_{c1}$ and $B_{c2}$ are substantially the same as those in the circuit of Fig. 2. The only difference between the circuits of Fig. 2 and Fig. 6 is that, in Fig. 5, transistors $Q_{71}$ , $Q_{72}$ , $Q_{73}$ , ... are provided between each pair of bit lines BL and $\overline{BL}$. The gate of each transistor $Q_{71}$ , $Q_{72}$ , $Q_{73}$ , ... is connected to the third control line $N_3$. Because of the folded-bit line structure, the third control line $N_3$ does not take a long way around the sense amplifiers SA as in the circuit of Fig. 2. Therefore, the short circuit between each pair of bit lines in the circuit of Fig. 6 is effected rapidly in comparison with the circuit of Fig. 2. However, the presense of the third control line $N_3$ still causes an obstruction to high integration.

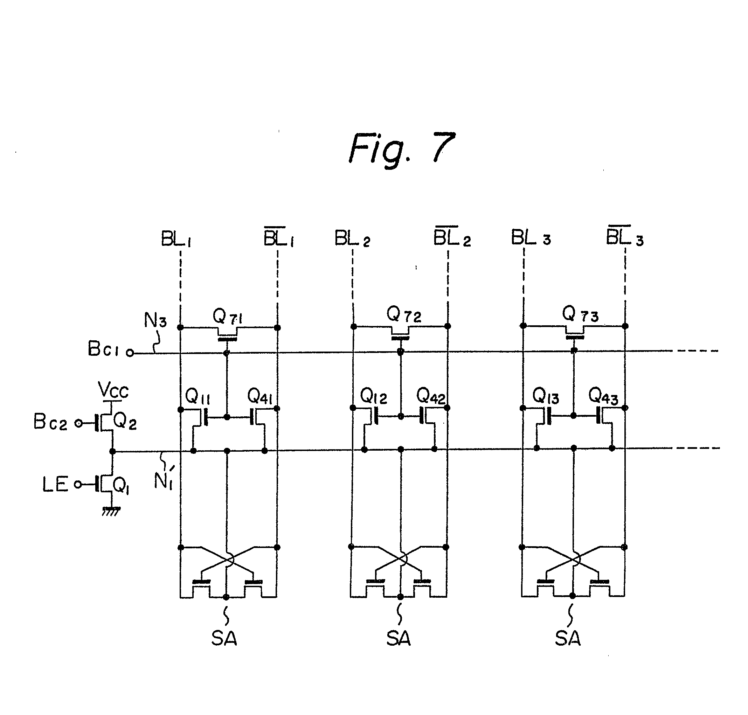

Fig. 7 is a circuit diagram illustrating a dynamic RAM in which the third control line $N_3$ is eliminated, according to another embodiment of the present invention. In Fig. 7, instead of two control lines $N_1$ and $N_2$ in Fig. 6, a single control line $N_1'$ is provided. The connecting pattern between the control line $N_1'$ and the elements in the circuit of Fig. 7 is quite the same as in the circuit of Fig. 3 and therefore, is not explained here. Although, memory cells and a dummy memory cell connected to each bit line is not illustrated in Fig. 7 for the purpose of simplicity, a number of memory cells and a dummy memory cell are connected to each bit line in practice.

According to this second embodiment, the advantage of high integration is also obtained. But the effect of high speed shorting operation is not the specific advantage of this embodiment.

From the foregoing description, it will be apparent that, in embodiments of the present invention, in a dynamic-type semiconductor memory device, the number of wiring lines in the periphery of the sense amplifiers can be decrease so that the integration degree can be improved and the time required for shorting each pair of bit lines can be shortened.

It is apparent to those skilled in the art that the present invention is not restricted to the foregoing embodiments but various changes and modifications are possible without departing from the scope of the claimed invention. For example, the present invention may be applied to any dynamic-type semiconductor memory device having any memory capacity.

CLAIMS

1. A semiconductor memory device comprising:

a plurality of pairs of bit lines ($BL_1$, $\overline{BL}_1$), ($BL_2$, $\overline{BL}_2$), ..., each pair of said bit lines being short circuited and precharged to a reference potential level before a reading operation;

a plurality of word lines ($WL_1$, $WL_2$) intersecting said bit lines;

a plurality of dynamic-type memory cells ($M_{cl1}$, $M_{cl2}$, ...), each of said memory cells being connected between one of said bit lines and one of said word lines; and

a plurality of sense amplifiers (SA), each of said sense amplifiers having a terminal to activate the sense amplifier for detecting potential difference between the bit lines of one of the said pairs;

characterised in that:

a control line ($N_1'$) connected to each said terminal for activating said sense amplifiers is commonly used as a control line for bringing about the precharging of the said pairs of bit lines.

2. A semiconductor memory device as set forth in Claim 1, wherein each of said sense amplifiers comprises two transistors ($Q_{21}$, $Q_{31}$), ($Q_{22}$, $Q_{32}$), ... forming a flip flop, the sources of said two transistors being connected to said terminal.

3. A semiconductor memory device as set forth in Claim 1, wherein a short circuiting transistor ($Q_{11}$ or $Q_{12}$, ..., $Q_{41}$, $Q_{42}$, ...) is inserted between said control line and each of said bit lines.

4. A semiconductor memory device as set forth in Claim 1, wherein a precharging transistor ($Q_2$) is inserted between a power supply and said control line.

5. A semiconductor memory device as set forth in Claim 1, wherein an activating transistor ($Q_1$) for activating said sense amplifiers is inserted between said control line and the ground.

6.    A semiconductor memory device as set forth in Claim 1, wherein a short circuiting transistor ($Q_{71}$ or $Q_{72}$ , ...) is inserted between the bit lines of each pair.

7.    A semiconductor memory device as set forth in Claim 1, wherein said dynamic type memory cell comprises:
                a MIS transistor having a gate connected to one of said word lines and a source or a drain connected to one of said bit lines; and
                a capacitor connected to said drain or source of said MIS transistor.

# Fig. 1

0053877

2/5

Fig. 2

Fig. 3

Fig. 4

Fig. 5

Fig. 6

Fig. 7

0053877